# EUROPEAN PATENT SPECIFICATION

(11) **EP 3 901 988 B1**
(45) Date of publication and mention of the grant of the patent: **31.07.2024**
(21) Application number: 20744838.2
(22) Date of filing: 13.01.2020
(51) Int. Cl.: H01L 21/20, H01L 33/04, H01S 5/50, H01S 5/34, H01S 5/10, H01S 5/20, H01S 5/40

(54) **QUANTUM DOT SEMICONDUCTOR OPTICAL AMPLIFIER AND PREPARATION METHOD THEREFOR**
OPTISCHER QUANTENPUNKT-HALBLEITERVERSTÄRKER UND VERFAHREN ZU SEINER HERSTELLUNG
AMPLIFICATEUR OPTIQUE SEMI-CONDUCTEUR À POINTS QUANTIQUES ET SON PROCÉDÉ DE PRÉPARATION

(30) Priority: 21.01.2019 CN 201910053840
(43) Date of publication of application: 27.10.2021
(73) Proprietor: Huawei Technologies Co., Ltd., Longgang District, Shenzhen, Guangdong 518129 (CN)
(72) Inventor: ZHANG, Xin, Shenzhen, Guangdong 518129 (CN); MI, Guangcan, Shenzhen, Guangdong 518129 (CN); JI, Ruiqiang, Shenzhen, Guangdong 518129 (CN)
(74) Representative: Pfenning, Meinig & Partner mbB
(86) International application number: PCT/CN2020/071787
(87) International publication number: WO 2020/151524

(56) References cited:
- WO-A1-2018/141974
- CN-A- 101 331 590
- CN-A- 101 867 155
- CN-A- 105 518 951
- CN-A- 106 898 543
- US-A1- 2001 028 755
- US-A1- 2007 047 068
- US-A1- 2008 116 465
- US-A1- 2012 243 075
- US-A1- 2018 351 037
- US-A1- 2018 374 988
- US-B1- 7 474 811
- TATEBAYASHI J ET AL: "Highly uniform, multi-stacked InGaAs/GaAs quantum dots embedded in a GaAs nanowire", APPLIED PHYSICS LETTERS, AMERICAN INSTITUTE OF PHYSICS, 2 HUNTINGTON QUADRANGLE, MELVILLE, NY 11747, vol. 105, no. 10, 8 September 2014 (2014-09-08), XP012189669, ISSN: 0003-6951, [retrieved on 19010101], DOI: 10.1063/1.4895597

## Description

### TECHNICAL FIELD

This application relates to the field of optical device technologies, and in particular, to a quantum dot semiconductor optical amplifier and a preparation method therefor.

### BACKGROUND

A quantum dot semiconductor optical amplifier (quantum dot semiconductor optical amplifier, QD-SOA) has advantages of electric drive, small package, easy deployment, and low price, and is an optical amplification device of great potential currently.

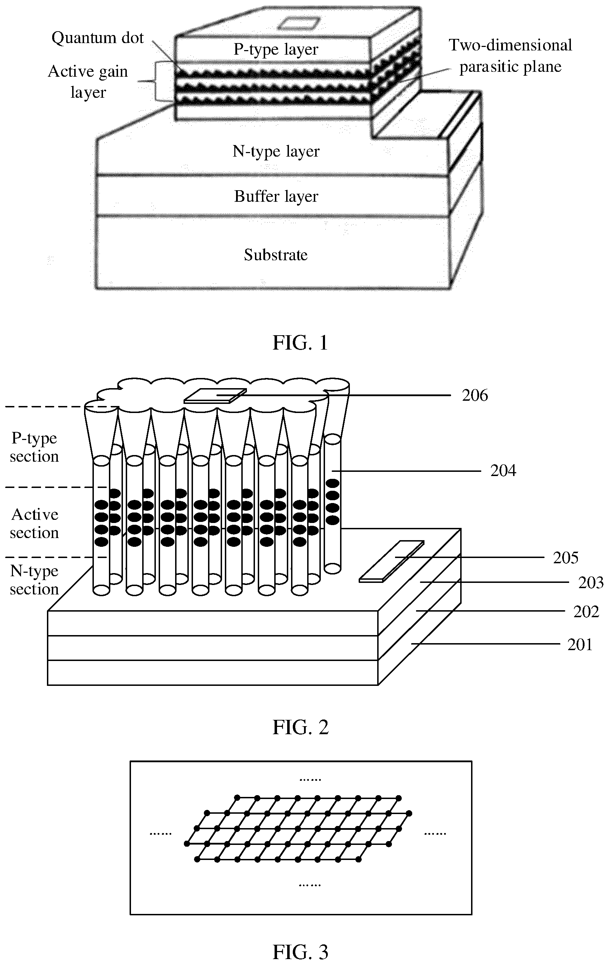

FIG. 1 is a schematic structural diagram of a quantum dot semiconductor optical amplifier in the related art. As shown in FIG. 1, the QD-SOA includes a substrate, a buffer layer located above the substrate, and an n-type layer, an active gain layer, and a p-type layer that are obtained by sequential epitaxial growth from the buffer layer. The active gain layer includes a plurality of two-dimensional parasitic planes, and each time one two-dimensional parasitic plane is generated, epitaxial growth is performed by using the two-dimensional parasitic plane as a carrier, to obtain a plurality of quantum dots on the two-dimensional parasitic plane.

The plurality of quantum dots are obtained by performing epitaxial growth by using the two-dimensional parasitic plane as a carrier, which causes growth positions and sizes of the quantum dots to be random and difficult to control. As a result, alloy components of the quantum dots located on the same two-dimensional parasitic plane fluctuate greatly, which leads to performance problems of the device such as a relatively large wavelength correlation, an excessively wide covered wave band, and a relatively large noise figure.

In the document by TATEBAYASHI: "Highly uniform, multi-stacked InGaAs/GaAs quantum dots embedded in a GaAs nanowire", Applied Physics Letters, vol. 105, no. 10, 8 September 2014, XP012189669 a highly uniform, dense stack of In_{0.22}Ga_{0.78}As/GaAs quantum dot (QD) structures in a single GaAs nanowire (NW) is demonstrated. The size (and hence emission energy) of individual QD is tuned by careful control of the growth conditions based on a diffusion model of morphological evolution of NWs and optical characterization. By carefully tailoring the emission energies of individual QD, dot-to-dot inhomogeneous broadening of QD stacks in a single NW can be as narrow as 9.3 meV This method provides huge advantages over traditional QD stack using a strain-induced Stranski-Krastanow growth scheme. It is shown that it is possible to fabricate up to 200 uniform QDs in single GaAs NWs using this growth technique without degradation of the photoluminescence intensity.

In document US 2001/028755 A1 an optical processor of a wavelength-division multiplex optical signal is presented including a non-linear optical device having an active layer containing therein a number of self-organized quantum dots with respective absorption wavelengths. The quantum dots collectively form a continuous optical absorption spectrum in the wavelength range of the wavelength-division multiplex optical signal.

In document US 7 474 811 B1 a photonic apparatus and system are presented employing a plurality of nanowires distributed in a low-index optical waveguide. The plurality of nanowires collectively one or more of produces, enhances, modulates and detects an optical field. The low-index optical waveguide confines the optical field in a vicinity of the plurality of nanowires. The photonic system includes a circuit to one or more of electrically bias the plurality of nanowires and collect electrons produced in the plurality of nanowires.

In document US 2012/243075 A1 a gain-clamped semiconductor optical amplifier is presented comprising: at least one first surface; at least one second surface, each second surface facing and electrically isolated from a respective first surface; a plurality of nanowires connecting each opposing pair of the first and second surfaces in a bridging configuration; and a signal waveguide overlapping the nanowires such that an optical signal traveling along the signal waveguide is amplified by energy provided by electrical excitation of the nanowires.

In document US 2018/374988 A1 InGaN/GaN quantum layer nanowire light emitting diodes are fabricated into a single cluster capable of exhibiting a wide spectral output range. The nanowires having InGaN/GaN quantum layers formed of quantum dots are tuned to different output wavelengths using different nanowire diameters, for example, to achieve a full spectral output range covering the entire visible spectrum for display applications. The entire cluster is formed using a monolithically integrated fabrication technique that employs a single-step selective area epitaxy growth.

In document US 2018/351037 A1 is disclosed an optoelectronic device comprising at least one three-dimensional semiconductor structure extending along a longitudinal axis substantially orthogonal to a plane of a substrate on which it lies, and comprising a first doped portion, extending from a face of the substrate along the longitudinal axis; an active portion comprising at least one quantum well, extending from the first doped portion along the longitudinal axis; and a second doped portion, extending from the active portion along the longitudinal axis.

### SUMMARY

Embodiments of this application provide a quantum dot semiconductor optical amplifier and a preparation method therefor, to resolve performance problems of a quantum dot semiconductor optical amplifier in the related art such as a relatively high wavelength correlation, an excessively wide covered wave band, and a relatively large noise figure.

The invention is defined in the independent claims. Preferred embodiments are given in the dependent claims.

According to a first aspect, a quantum dot semiconductor optical amplifier QD-SOA is provided, where the quantum dot semiconductor optical amplifier includes an epitaxial wafer, a buffer layer, a pre-etching layer, a plurality of nanowires, an n-electrode, and a p-electrode.

The buffer layer is located on an upper surface of the epitaxial wafer, the pre-etching layer is located on an upper surface of the buffer layer, and the pre-etching layer includes a plurality of localization etching holes. The plurality of localization etching holes penetrate the pre-etching layer to expose the buffer layer. The plurality of nanowires are in a one-to-one correspondence to the plurality of localization etching holes, a bottom end of each nanowire is in contact with a bottom of a corresponding localization etching hole, and a top end passes through the corresponding localization etching hole. A height of each nanowire is greater than a depth of a corresponding localization etching hole, and each nanowire includes an n-type section, an active section, and a p-type section, where the active section is embedded with a plurality of layers of quantum dots. The n-electrode is located on a surface of the epitaxial wafer, and the p-electrode is located above the plurality of nanowires. A bottom end of the p-type section is in contact with the top end of the active section, a cross-sectional area of the p-type section gradually increases from the bottom end to a top end of the p-type section until a plurality of p-type sections adjacent to each other in the plurality of p-type sections included in the plurality of nanowires come into contact with each other to form a two-dimensional plane for subsequent preparation of the p-electrode on the two-dimensional plane.

In this embodiment of this application, the pre-etching layer includes a plurality of localization etching holes. Each of the plurality of nanowires protrudes out of a corresponding localization etching hole. In addition, the active section of each nanowire is embedded with a plurality of layers of quantum dots. In other words, in this embodiment of this application, the quantum dots are grown by using a nanowire with a fixed position as a carrier. In this way, compared with a quantum dot grown by using a two-dimensional plane as a carrier in the related art, a position of the quantum dot in the active section in this application is fixed and a size is controllable. Because the position of the quantum dot is fixed and the size is controllable, it is avoided that quantum dots located at a same height in active sections of a plurality of nanowires form a two-dimensional plane. In addition, because the size of the quantum dot is controllable, relatively large fluctuation of alloy components caused by random sizes of the quantum dots can be effectively avoided, so that wavelength correlation of a finally prepared quantum dot semiconductor optical amplifier can be reduced, a width of a covered wave band is properly adjusted, and a noise figure is reduced.

Optionally, based on different requirements on optical performance of the device, distances between every two adjacent layers of the quantum dots in the active section may be a first height or periodically arranged.

Optionally, a cross-sectional area of the p-type section is not less than a cross-sectional area of the n-type section, and is not less than a cross-sectional area of the active section.

Optionally, the n-electrode is located on a lower surface of the epitaxial wafer; or the quantum dot semiconductor optical amplifier includes a deep trench, the deep trench penetrates the pre-etching layer and the buffer layer to expose an upper surface of the epitaxial wafer, the n-electrode is located in the deep trench, and a lower surface of the n-electrode is in contact with the exposed upper surface of the epitaxial wafer.

If the n-electrode is located on the lower surface of the epitaxial wafer, the n-electrode may be directly attached to the lower surface of the epitaxial wafer, and an electrode preparation process is simple and has lower costs. If the n-electrode is located on the upper surface of the epitaxial wafer, the n-electrode and the p-electrode form a coplanar electrode. In this way, the n-electrode and the p-electrode may subsequently be powered in a same power supply manner, and the power supply is simple.

Optionally, the plurality of localization etching holes are circular holes or regular polygon holes.

Based on different crystalline structures of materials for forming the nanowire, a shape of a cross section of the nanowire may be a regular polygon or a circle. Therefore, in this embodiment of this application, shapes of the plurality of localization etching holes for defining a growth position of the nanowire may match the shape of the cross section of the nanowire.

Optionally, the plurality of localization etching holes form a plurality of specific shapes that are periodically arranged, and the specific shape is any one of a regular triangle, a rectangle, a parallelogram, and a regular hexagon.

Optionally, the quantum dot semiconductor optical amplifier further includes a first external driver module by electrical pins, a second external driver module by electrical pins, a first pigtail, a second pigtail, a first optical coupling component, and a second optical coupling component. The first external driver module by electrical pins is connected to the n-electrode, and the second external driver module by electrical pins is connected to the p-electrode. The first pigtail is connected, by using the first optical coupling component, to one side of an active gain layer formed by the plurality of active sections that are included in the plurality of nanowires, and the second pigtail is connected to the other side of the active gain layer by using the second optical coupling component.

According to a second aspect, a method for preparing a quantum dot semiconductor optical amplifier is provided, where the method includes: depositing a buffer layer on an upper surface of an epitaxial wafer; preparing an n-electrode on a surface of the epitaxial wafer, and depositing a pre-etching layer on the buffer layer; performing etching on the pre-etching layer to obtain a plurality of localization etching holes, where the plurality of localization etching holes penetrate the pre-etching layer to expose the buffer layer; growing one nanowire along an axial direction of each of the plurality of localization etching holes from a bottom of the localization etching hole, where the nanowire includes an n-type section, an active section, and a p-type section from bottom to top in a growth direction, and the active section is embedded with a plurality of layers of quantum dots; and preparing a p-electrode above a plurality of nanowires that are formed along axial directions of the plurality of localization etching holes, to obtain a quantum dot semiconductor optical amplifier.

Because the quantum dot is grown by using the nanowire with a fixed position as a carrier, a degree of freedom of the growth of the quantum dot is limited, so that a position of the quantum dot is fixed and a size is controllable. Because the position of the quantum dot is fixed and the size is controllable, it is avoided that quantum dots located at a same height in active sections of a plurality of nanowires form a two-dimensional plane. In addition, relatively large fluctuation of alloy components caused by random sizes of the quantum dots is effectively avoided, so that wavelength correlation of the device is reduced, a width of a covered wave band is properly adjusted, and a noise figure is reduced.

Optionally, distances between every two adjacent layers of the quantum dots in the active section are a first height.

Optionally, a cross-sectional area of the p-type section is greater than a cross-sectional area of the n-type section, and is greater than a cross-sectional area of the active section.

Optionally, an implementation of preparing an n-electrode on a surface of the epitaxial wafer may be: preparing the n-electrode on a lower surface of the epitaxial wafer on which the buffer layer is formed. In this implementation, the n-electrode may be directly attached to the lower surface of the epitaxial wafer by using an additional electrode preparation process, and a preparation process is simple and has low costs.

Optionally, another implementation of preparing an n-electrode on a surface of the epitaxial wafer may be: etching a deep trench on the pre-etching layer and the buffer layer, where the deep trench penetrates the pre-etching layer and the buffer layer to expose an upper surface of the epitaxial wafer; and preparing the n-electrode in the deep trench. In this implementation, because the n-electrode is located on the upper surface of the epitaxial wafer, the p-electrode is located above the plurality of nanowires. Therefore, the n-electrode and the p-electrode form a coplanar electrode. During subsequent power supply, the n-electrode and the p-electrode may be powered in a same power supply manner, and the power supply is simple.

Optionally, an implementation process of performing etching on the pre-etching layer to obtain a plurality of localization etching holes may be: generating a mask plate based on a preset geometry; and performing etching on the pre-etching layer by using the mask plate, to obtain the plurality of localization etching holes. The preset geometry is any one of a regular triangle, a rectangle, a parallelogram, and a regular hexagon, the mask plate includes a plurality of the preset geometries, and the plurality of preset geometries are periodically arranged on the mask plate. The etching accuracy can be improved effectively by performing etching by using the mask plate. In addition, when etching is performed based on different mask plates, arrangements of the plurality of nanowires grown from the plurality of localization etching holes that are obtained by etching are different, and therefore obtained optical performance of the device is also different. In other words, in this embodiment of this application, the mask plate may be designed based on a requirement on optical performance of the device, to perform etching.

According to a third aspect, a computer program product including instructions is provided. When the computer program product is run on a computer, the computer is enabled to perform the method for preparing a quantum dot semiconductor optical amplifier according to the second aspect.

Technical effects obtained in the second aspect and the third aspect are similar to the technical effects obtained by corresponding technical means in the first aspect, and details are not described herein again.

Beneficial effects brought by the technical solutions provided in this application include at least the following: In the embodiments of this application, etching is performed on a pre-etching layer to obtain a plurality of localization etching holes. Then, one nanowire is grown along a depth direction of each localization etching hole. An active section included in the nanowire is embedded with a plurality of quantum dots. A position of the nanowire is fixed, which limits a degree of freedom of the growth of the quantum dot, so that a growth position and a size of the nanowire can be controlled effectively. In this way, fluctuation of alloy components of the quantum dots is reduced, thereby reducing wavelength correlation of the QD-SOA, narrowing a width of a covered wave band, and reducing a noise figure.

### BRIEF DESCRIPTION OF DRAWINGS

FIG. 1 is a schematic structural diagram of a quantum dot semiconductor optical amplifier in the related art;
FIG. 2 is a schematic structural diagram of a quantum dot semiconductor optical amplifier according to an embodiment of this application;
FIG. 3 is a schematic arrangement diagram of a plurality of etching holes on a pre-etching layer according to an embodiment of this application;
FIG. 4 is another schematic arrangement diagram of a plurality of etching holes on a pre-etching layer according to an embodiment of this application;
FIG. 5 is a flowchart of a method for preparing a quantum dot semiconductor optical amplifier according to an embodiment of this application; and
FIG. 6 is a diagram of spectral comparison between a quantum dot semiconductor optical amplifier in the related art and a quantum dot semiconductor optical amplifier in this application according to an embodiment of this application.

### DESCRIPTION OF EMBODIMENTS

To make the objectives, technical solutions, and advantages of this application clearer, the following further describes the implementations of this application in detail with reference to the accompanying drawings.

Before the embodiments of this application are described in detail, an application scenario involved the embodiments of this application is first described.

In an optical communications system, a power loss occurs in a process of transmitting an optical signal through an optical fiber. Therefore, to ensure a transmission distance of the optical signal, an optical amplifier is used to amplify power of the optical signal. The optical amplifier may be disposed at different positions in the optical communications system. For example, the optical amplifier is disposed at a transmit end in the optical communications system, to enhance power of an optical signal output from the transmit end, to further extend a relay distance. Alternatively, the optical amplifier is disposed on a transmission line in the optical communications system, to amplify an optical signal whose power loss occurs in a transmission process, to extend a transmission relay distance.

Currently, common optical amplifiers include a semiconductor optical amplifier (semiconductor optical amplifier, SOA) and an erbium-doped fiber amplifier (erbium-doped fiber amplifier, EDFA). The SOA has advantages such as convenient electric drive, compact package, flexible deployment, and low price. Therefore, the SOA is more applicable to an application scenario with "high integration and low costs" than the EDFA. A quantum dot semiconductor optical amplifier provided in the embodiments of this application is a type of SOA. Therefore, the quantum dot semiconductor optical amplifier provided in this application can also be applied to an application scenario with "high integration and low costs". Certainly, the quantum dot semiconductor optical amplifier provided in this application may be further applied to other scenarios, to amplify an optical signal. This is not specifically limited in the embodiments of this application.

FIG. 2 is a schematic structural diagram of a quantum dot semiconductor optical amplifier according to an embodiment of this application. As shown in FIG. 2, the quantum dot semiconductor optical amplifier includes an epitaxial wafer 201, a buffer layer 202, a pre-etching layer 203, a plurality of nanowires 204, an n-electrode 205, and a p-electrode 206.

A material of the epitaxial wafer 201 may be an III-V group material, for example, InP or GaAs. Alternatively, a material of the epitaxial wafer 201 may be a silicon material.

Because problems of a crystal lattice mismatch and a crystal lattice orientation mismatch usually exist between the nanowire 204 and the epitaxial wafer 201, it is difficult to nucleate and grow the nanowire 204 from the epitaxial wafer 201. Based on this, an upper surface of the epitaxial wafer 201 is usually covered with the buffer layer 202, so that the nanowire can be nucleated and grown on the buffer layer 202. A material of the buffer layer 202 may be In*ₓ*Ga*₁₋ₓ*As, Al*ₓ*Ga*₁₋ₓ*N, or the like. In addition, a thickness of the buffer layer 202 generally ranges from tens of nanometers to hundreds of nanometers.

The pre-etching layer 203 is located on an upper surface of the buffer layer 202. A material of the pre-etching layer 203 may be a material that can be easily etched and on which no nanowire is nucleated and grown, such as SiOz or TiOz. In addition, a thickness of the pre-etching layer 203 may range from hundreds of nanometers to tens of microns.

The pre-etching layer 203 includes a plurality of localization etching holes. The localization etching holes penetrate the pre-etching layer to expose the buffer layer 202. An axial direction of each localization etching hole may be parallel to a thickness direction of the pre-etching layer 203. Alternatively, a specific included angle may exist between an axial direction of each localization etching hole and a thickness direction of the pre-etching layer 203. A magnitude of the included angle may range from 0 to 10 degrees. In addition, each localization etching hole directly reaches the upper surface of the buffer layer 202 or protrudes into the buffer layer 202 to expose the buffer layer 202.

Optionally, in this embodiment of this application, the nanowire 204 may be a hexagonal prism, a quadrangular prism, a cylinder, or the like based on different crystalline structures of materials that constitute the nanowire 204. Based on this, a shape of the localization etching hole may be a circle. In this way, regardless of the shape of the nanowire 204, a diameter of the localization etching hole can be controlled to ensure that the nanowire can be grown from the localization etching hole. Alternatively, a shape of the localization etching hole may be determined based on the shape of the nanowire. For example, when the shape of the nanowire is a hexagonal prism, the localization etching hole may be a hexagonal shape. Alternatively, when the shape of the nanowire is a quadrangular prism, the localization etching hole may be a quadrilateral, or the like.

Optionally, the plurality of localization etching holes may form a plurality of specific shapes that are periodically arranged, and the specific shape may be a polygon such as a triangle, a quadrilateral, or a regular hexagon. In other words, the plurality of localization etching holes may be divided into a plurality of array units, and each array unit includes at least three localization etching holes. The localization etching holes included in each array unit form one specific shape. In addition, the plurality of array units may be periodically arranged.

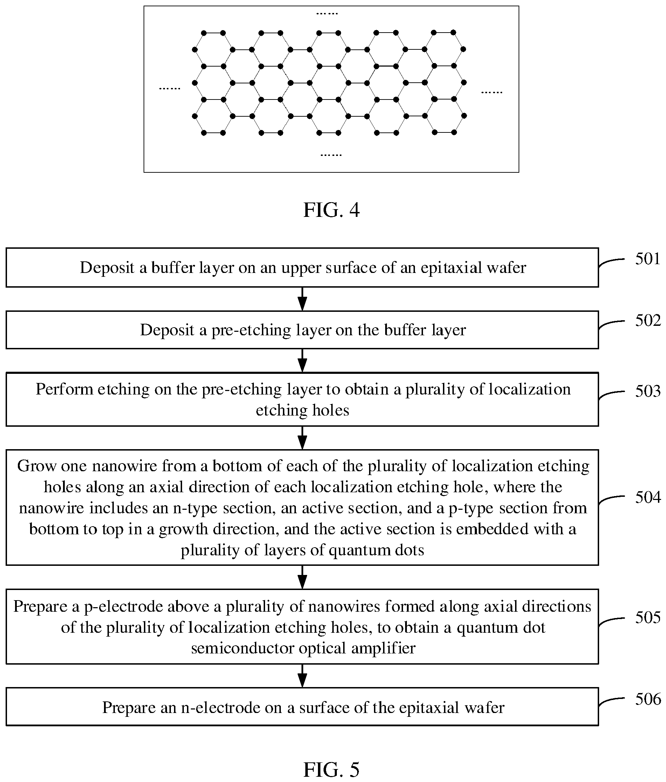

For example, as shown in FIG. 3, four localization etching holes that are adjacent to each other in the plurality of localization etching holes form one array unit whose shape is a parallelogram. The plurality of localization etching holes form a plurality of array units in total, and the plurality of array units are periodically arranged. For another example, six localization etching holes adjacent to each other in the plurality of localization etching holes in FIG. 4 form an array unit whose shape is a regular hexagon. The plurality of localization etching holes form a plurality of array units in total, and the plurality of array units are periodically arranged.

The plurality of nanowires 204 are in a one-to-one correspondence to the plurality of localization etching holes on the pre-etching layer 203. A bottom end of each nanowire 204 is in contact with the buffer layer 202 exposed by a corresponding localization etching hole, and the other end passes through the corresponding localization etching hole. In addition, a height of each nanowire 204 is greater than a depth of a corresponding localization etching hole.

It should be noted that, each nanowire 204 includes three sections: an n-type section, an active section, and a p-type section. A bottom end of the n-type section is in contact with the buffer layer 202, and a top end of the n-type section protrudes out of the localization etching hole. In this embodiment of this application, the n-type sections of the plurality of nanowires form an n-type cladding layer, and are used to constrain a light beam, to ensure an effective refractive index of the light beam. A height of the n-type sections of the plurality of nanowires 204 determines a thickness of the formed n-type cladding layer. The thickness of the n-type cladding layer affects the effective refractive index of the light beam and a magnitude of a drive current of the quantum dot semiconductor optical amplifier. Therefore, in this embodiment of this application, the height of the n-type sections may be determined based on a requirement on the effective refractive index of the light beam and a requirement on the magnitude of the drive current. Usually, the height of the n-type sections ranges from tens of nanometers to a few microns.

A bottom end of the active section is in contact with the top end of the n-type section. The active section is embedded with a plurality of layers of quantum dots. For example, each layer of quantum dots is wrapped inside the active section. It should be noted that, based on different requirements on optical performance of the device, distances between every two adjacent layers of quantum dots in the plurality of layers of quantum dots may be a first height. It should be further noted that, the plurality of layers of quantum dots may also be referred to as a plurality of quantum dot layers.

Alternatively, distances between every two adjacent layers of quantum dots in the plurality of layers of quantum dots may be periodically arranged. For example, based on an order from the bottom end to a top end of the active section, a distance between a first layer of quantum dots and a second layer of quantum dots is h₁, a distance between the second layer of quantum dots and a third layer of quantum dots is h₂, a distance between the third layer of quantum dots and a fourth layer of quantum dots is h₁, a distance between the fourth layer of quantum dots and a fifth layer of quantum dots is h₂, and so on, cyclically.

It should be noted that, in this embodiment of this application, a height of the active section is less than the height of the n-type section. Usually, the height of the active section ranges from tens of nanometers to hundreds of nanometers. In addition, the active sections of the plurality of nanowires constitute an active gain layer of the QD-SOA. Each quantum dot in the active gain layer is embedded in the active section. Therefore, a growth dimension of the quantum dot is limited, thereby limiting a size and a position of the quantum dot. Compared with a quantum dot using a two-dimensional plane as a carrier, the size and the position of the quantum dot are effectively controlled, thereby reducing fluctuation of alloy components of the quantum dots, so that wavelength correlation of the device is reduced, a width of a covered wave band is properly adjusted, and a noise figure is reduced.

According to the invention as claimed, a bottom end of the p-type section is in contact with the top end of the active section. In the invention as claimed, as shown in FIG. 2, a cross-sectional area of the p-type section gradually increases from the bottom end to a top end of the p-type section until a plurality of p-type sections adjacent to each other in the plurality of p-type sections included in the plurality of nanowires come into contact with each other, to form a two-dimensional plane with a specific thickness, for subsequent preparation of the p-electrode on the two-dimensional plane. Because the plurality of p-type sections come into contact with each other to form a two-dimensional plane, an electrode material does not penetrate into gaps between the plurality of nanowires in the process of preparing the p-electrode, thereby avoiding causing a short circuit. In addition, the two-dimensional plane is obtained by connecting top ends of the plurality of nanowires to each other. Therefore, the p-electrode prepared at any position on the two-dimensional plane can be conducted with each nanowire, thereby facilitating subsequent preparation of the p-electrode. A plurality of p-type sections included in the plurality of nanowires constitute a p-type cladding layer of the quantum dot semiconductor optical amplifier. A thickness of the p-type cladding may also be adjusted and designed based on an effective refractive index of an optical signal and a magnitude of a drive current of the device. Details are not described in this embodiment of this application.

In a possible implementation, not in accordance with the invention as claimed, a cross-sectional area of the p-type section may also remain consistent with cross-sectional areas of the active section and the n-type section. In this case, gaps between the plurality of p-type sections included in the plurality of nanowires may be filled with an organic polymer insulating material, so that top ends of the plurality of p-type sections and the filled insulating material form a two-dimensional plane, thereby facilitating subsequent preparation of the p-electrode on the two-dimensional plane.

The p-electrode 206 is located on an upper surface of the two-dimensional plane formed after the plurality of p-type sections come into contact.

The n-electrode 205 may be located on a lower surface or the upper surface of the epitaxial wafer 201. If the n-electrode 205 is located on the lower surface of the epitaxial wafer 201, the n-electrode 205 may be directly attached to the lower surface of the epitaxial wafer 201. An electrode preparation process is simple and has lower costs. If the n-electrode 205 is located on the upper surface of the epitaxial wafer 201, during preparation of the n-electrode 205, a deep trench needs to be dug from the upper surface of the pre-etching layer 203, and a trench bottom directly reaches the upper surface of the epitaxial wafer. Then, the n-electrode 205 is prepared in the deep trench. In the second manner, the n-electrode 205 and the p-electrode 206 form a coplanar electrode. In this way, the n-electrode 205 and the p-electrode 206 may subsequently be powered in a same power supply manner, and the power supply is simpler than that in the first manner.

Optionally, in this embodiment of this application, the quantum dot semiconductor optical amplifier may further include a first external driver module by electrical pins, a second external driver module by electrical pins, a first pigtail, a second pigtail, a first optical coupling component, and a second optical coupling component.

The first external driver module by electrical pins and the second external driver module by electrical pins may include a same quantity of external drives by electrical pins. For example, each external driver module by electrical pins may include seven external drivers by electrical pins. The specific quantity is not limited in this embodiment of this application.

It should be noted that, the first external driver module by electrical pins is connected to the n-electrode, and the second external driver module by electrical pins is connected to the p-electrode. The plurality of external drives by electrical pins included in the two external driver modules by electrical pins may supply power to the quantum dot semiconductor optical amplifier.

The first pigtail may be connected, by using the first optical coupling component, to one side of the active gain layer formed by the plurality of active sections, and the second pigtail may be connected to the other side of the active gain layer by using the second optical coupling component. A light beam may be input to the quantum dot semiconductor optical amplifier through the first pigtail. The light beam whose power is amplified by the quantum dot semiconductor optical amplifier may be output through the second pigtail.

In addition, the quantum dot semiconductor optical amplifier may further include a hermetic packaging structure and a mechanical housing, to implement packaging of the foregoing components.

In this embodiment of this application, a position of the nanowire that is from the bottom of the localization etching hole with a fixed position and extends along the axial direction of the localization etching hole is also fixed. In this way, the quantum dot is grown by using the nanowire as a carrier, and a degree of freedom of the growth of the quantum dot is limited, so that the position of the quantum dot is fixed and the size is controllable. Because the position of the quantum dot is fixed and the size is controllable, it is avoided that quantum dots located at a same height in active sections of a plurality of nanowires form a two-dimensional plane. In addition, relatively large fluctuation of alloy components caused by random sizes of the quantum dots can also be effectively avoided, so that wavelength correlation of the device is reduced, a width of a covered wave band is properly adjusted, and a noise figure is reduced.

It should be noted that, in this embodiment of this application, the components shown in FIG. 2 to FIG. 4 are merely schematic diagrams of positions and forms of the components. A size proportion of each component shown in the accompanying drawings cannot represent an actual size proportion of each component.

FIG. 5 is a method for preparing a quantum dot semiconductor optical amplifier according to an embodiment of this application. As shown in FIG. 5, the method may include the following steps.

Step 501: Deposit a buffer layer on an upper surface of an epitaxial wafer.

For description of the epitaxial wafer, refer to the related description in the foregoing embodiment. Details are not described herein again in this embodiment of this application.

Because a crystal lattice mismatch exists between a material of the epitaxial wafer and a material of the nanowire, it is difficult to directly grow the nanowire on the epitaxial wafer. Based on this, a buffer layer may be deposited on the upper surface of the epitaxial wafer by using a molecular beam epitaxy or chemical vapor deposition method, so that the nanowire can be nucleated and grown on the buffer layer.

Step 502: Deposit a pre-etching layer on the buffer layer.

After the buffer layer is deposited on the epitaxial wafer, a pre-etching layer used for etching may be further deposited on an upper surface of the buffer layer. For a material and a thickness of the pre-etching layer, refer to the foregoing embodiment.

Step 503: Perform etching on the pre-etching layer to obtain a plurality of localization etching holes.

After the pre-etching layer is prepared, etching may be performed on the pre-etching layer by using an ion etching (ion etching) technology, to obtain a plurality of localization etching holes.

An initial etching position may be preset on the pre-etching layer, and a first localization etching hole is etched at the initial etching position. The initial etching position may be located at a corner point of the pre-etching layer, or may be located at a center of the pre-etching layer. Then, starting from the initial etching position, one localization etching hole is etched every preset distance along a direction parallel to a long side of the pre-etching layer. After a distance between a position of the localization etching hole closest to a wide side of the pre-etching layer and the wide side of the pre-etching layer is less than the preset distance, a row of localization etching holes is obtained. Next, a next row of localization etching holes is etched based on the foregoing method. It should be noted that, distances between two adjacent rows of localization etching holes may be equal or different. This is not specifically limited in the embodiments of this application.

The foregoing mainly describes a method for etching localization etching holes row by row on the pre-etching layer. It is clearly that the localization etching holes may alternatively be etched on the pre-etching layer column by column in an etching method similar to the foregoing method. A difference lies in that: In this case, distances between every two adjacent localization etching holes in a same column are equal, and distances between two adjacent columns of localization etching holes may be equal or unequal.

Optionally, because positions of the localization etching holes determine positions of subsequent nanowires, distances between the localization etching holes determine distances between the subsequent nanowires, and the positions of the nanowires and the distances between the nanowires affect optical performance of the quantum dot semiconductor optical amplifier. Therefore, in this embodiment of this application, a mask plate including a preset geometry may be designed based on a requirement on the optical performance of the quantum dot semiconductor optical amplifier, and the mask plate is further used to perform etching on the pre-etching layer by using an ion etching technology in combination with a photolithography (photolithography) or electron-beam lithography (electron-beam lithography, EBL) technology, to obtain a plurality of localization etching holes. The preset geometry may be any one or any combination of geometric shapes such as a triangle, a rectangle, a parallelogram, and a regular hexagon.

When the mask plate is generated based on the preset geometry, a mask plate whose size is the same as that of the pre-etching layer may be generated, or a mask plate whose size is greater than that of the pre-etching layer may be generated. When the size of the mask plate is greater than the size of the pre-etching layer, the size of the mask plate is proportional to the size of the pre-etching layer. For example, a ratio of the size of the mask plate to the size of the pre-etching layer may be 40:1, 100:1, or the like. In addition, the mask plate includes a plurality of preset geometries of a same size and shape, and the plurality of preset geometries may be periodically arranged on the mask plate. A corner point of each preset geometry actually represents an etching position, namely, corresponds to a localization etching hole. For example, when the mask plate includes a plurality of parallelograms periodically arranged, a plurality of localization etching holes obtained by etching based on the mask plate are shown in FIG. 3. Correspondingly, when the mask plate includes a plurality of regular hexagons periodically arranged, a plurality of localization etching holes correspondingly obtained are shown in FIG. 4.

When the mask plate is used to perform etching on the pre-etching layer, if the size of the mask plate is the same as the size of the pre-etching layer, the geometries on the mask plate may be printed on the pre-etching layer in a contact-type or quasi-contact-type mask plate placement manner by using a photolithography or electron-beam lithography technology. Then, etching is performed on the pre-etching layer based on the printed geometries, to obtain a plurality of localization etching holes. If the size of the mask plate is in a specific proportion to the size of the pre-etching layer, the preset geometries on the mask plate can be reduced by a corresponding proportion by using photolithography or electron-beam lithography in cooperation with a high-precision projection device based on the proportion between the size of the mask plate and the size of the pre-etching layer, and then printed on the pre-etching layer. Then, etching is performed on the pre-etching layer based on the geometries printed on the pre-etching layer, to obtain a plurality of localization etching holes. In this case, the plurality of localization etching holes include a plurality of array units, and shapes formed by connection lines of the localization etching holes in each array unit are the preset geometries.

Optionally, in this embodiment of this application, the mask plate may alternatively be generated based on other preset rules. For example, it is assumed that the localization etching holes need to be denser in some regions of the pre-etching layer, and the localization etching holes need to be sparser in other regions. In this case, a mask plate including a plurality of through hole patterns with different density distribution features may be prepared based on a density requirement. Then, a plurality of through holes on the mask plate are printed on the pre-etching layer by using the related method described above. In this case, it is equivalent to that a plurality of etching positions are determined on the pre-etching layer. Next, etching is performed on the pre-etching layer based on the plurality of etching positions, to obtain a plurality of localization etching holes. In this case, the dense distribution of the plurality of localization etching holes is consistent with the dense distribution of the through hole patterns on the mask plate.

In addition, it should be noted that, in this embodiment of this application, etching may be performed in a direction perpendicular to a surface of the pre-etching layer, and an etching depth is greater than the thickness of the pre-etching layer, and less than a sum of thicknesses of the pre-etching layer and the buffer layer. In this way, axial directions of the plurality of localization etching holes obtained by etching are perpendicular to the surface of the pre-etching layer, and may penetrate the pre-etching layer to directly reach the buffer layer. Certainly, in an actual operation, the etching direction may also not be completely perpendicular to the surface of the pre-etching layer, but a specific inclination angle may exist, where the inclination angle usually may range from 0 to 10 degrees.

It should be noted that, in this embodiment of this application, if an n-electrode is subsequently prepared on an upper surface of an epitaxial layer, when the mask plate is generated, a region corresponding to the n-electrode on the mask plate is a blank region. In other words, no etching is performed in the region corresponding to the n-electrode on the pre-etching layer, and no nanowire is subsequently grown. In this way, a deep trench directly reaching the epitaxial wafer can be dug on the pre-etching layer to prepare the n-electrode.

Step 504: Grow one nanowire from a bottom of each of the plurality of localization etching holes along an axial direction of each localization etching hole, where the nanowire includes an n-type section, an active section, and a p-type section from bottom to top in a growth direction, and the active section is embedded with a plurality of layers of quantum dots.

In this step, an epitaxial growth technology may be used to grow one nanowire from each localization etching hole. For example, one nanowire may be grown, by using a molecular beam epitaxy (molecular beam epitaxy, MBE) technology, from the buffer layer exposed at the bottom of each localization etching hole. The molecular beam epitaxy technology is one of the epitaxial growth technologies. The molecular beam epitaxy technology refers to a technology of putting a required crystalline material into a jet furnace under an ultra-high vacuum condition, heating the jet furnace to make the crystalline material form molecular beams and proportionately eject the molecular beams from the jet furnace onto the buffer layer at a specific thermal motion speed, to perform crystalline epitaxial growth.

The following uses a process of generating one nanowire by using an MBE technology as an example to describe this step. In this embodiment of this application, for a growth process of each nanowire, refer to the following implementation.

A first crystalline material may be ejected to the buffer layer exposed at the bottom of the localization etching hole. The first crystalline material is nucleated on the buffer layer and grown along the axial direction of the localization etching hole. When a height of the grown nanowire reaches a second height, the nanowire with the second height is the n-type section. Then, composition of the first crystalline material is adjusted to obtain a second crystalline material. The second crystalline material continues to grow, and after a nanowire with a third height is further grown, composition of the second crystalline material may be adjusted to obtain a third crystalline material. An ejection amount of the third crystalline material is adjusted to grow a first quantum dot. This quantum dot section is the first layer of quantum dots. A size of the quantum dot is smaller than a cross-sectional area of the nanowire. After the first layer of quantum dots are grown, the third crystalline material is adjusted to the second crystalline material, the second crystalline material is naturally wrapped outside the first layer of quantum dots, and continues to grow. Starting from the first layer of quantum dots, one layer of quantum dots may be grown in the foregoing manner each time the nanowire with the third height is grown. After a quantity of layers of the quantum dots reaches a preset quantity, the second crystalline material is wrapped outside one layer of finally generated quantum dots, and a nanowire with a specific height continues to be generated, to complete preparation of an active section of the nanowire. After the preparation of the active section is completed, the composition of the second crystalline material is adjusted to obtain a fourth crystalline material. A nanowire of the fourth crystalline material continues to be generated. In addition, as the height of the nanowire increases, the ejection amount is gradually increased, to control the cross-sectional area of the nanowire to gradually increase. After adjacent nanowires come into contact with each other, the ejection amount remains unchanged, and the growth continues, to form a two-dimensional plane with a specific thickness. In this case, the preparation of the p-type section of the nanowire is completed. It should be noted that, for the height of the n-type section, the height of the active section, and the height of the p-type section, refer to related descriptions in the foregoing embodiment. Details are not described herein again in this embodiment of this application. Both the first crystalline material and the fourth crystalline material are materials including three or four components, but proportions of the components are different. The second crystalline material is a material including two or three components.

It should be further noted that, in the foregoing implementation, after the active section is prepared, a p-type section with a gradually increasing cross-sectional area may be formed by controlling the ejection amount of the crystalline material. In a possible implementation, not in accordance with the invention as claimed, the ejection amount may remain unchanged, to form a p-type section whose cross-sectional area is the same as those of the active section and the n-type section. In this case, after preparation of all p-type sections of a plurality of nanowires is completed, gaps between the p-type sections of the plurality of nanowires can be filled with an organic polymer insulating material, so that top ends of the p-type sections of the plurality of nanowires form a two-dimensional plane with the filled insulating material, thereby facilitating subsequent preparation of a p-electrode.

Optionally, in this embodiment of this application, one nanowire may be grown, by using a metal-organic chemical vapor deposition (metal-organic chemical vapor deposition, MOCVD) technology, from the buffer layer exposed at the bottom of each localization etching hole. A specific growth process of the nanowire is the same as the growth process in the molecular beam epitaxy technology described above. Details are not described herein again in this embodiment of this application.

In this embodiment of this application, a position of the nanowire that is from the bottom of the localization etching hole with a fixed position and extends along the axial direction of the localization etching hole is also fixed. In other words, a position of the quantum dot is fixed and a size is controllable. Therefore, it is avoided that quantum dots located at a same height in a plurality of active sections included in the plurality of nanowires form a two-dimensional plane. In addition, because the size of the quantum dot is controllable, relatively large fluctuation of alloy components caused by random sizes of the quantum dots can be effectively avoided, so that wavelength correlation of a finally prepared quantum dot semiconductor optical amplifier can be reduced, a width and a range of a covered wave band can be properly adjusted, and a noise figure is reduced.

Step 505: Prepare a p-electrode above a plurality of nanowires formed along axial directions of the plurality of localization etching holes, to obtain a quantum dot semiconductor optical amplifier.

After the plurality of nanowires are prepared, the p-electrode may be prepared, by using an additional electrode process, on an upper surface of the two-dimensional plane formed by the p-type sections of the plurality of nanowires.

Step 506: Prepare an n-electrode on a surface of the epitaxial wafer.

In this step, the n-electrode may be prepared directly on a lower surface of the epitaxial wafer by using the additional electrode process. Alternatively, a deep trench may be opened in a region on an upper surface of the pre-etching layer, and a trench bottom directly reaches the epitaxial wafer. Then, the n-electrode is prepared in the deep trench.

It should be noted that, in this embodiment of this application, step 505 and step 506 may be performed in any order. Alternatively, step 506 may be performed first, and then step 505 is performed. This is not limited in this embodiment of this application.

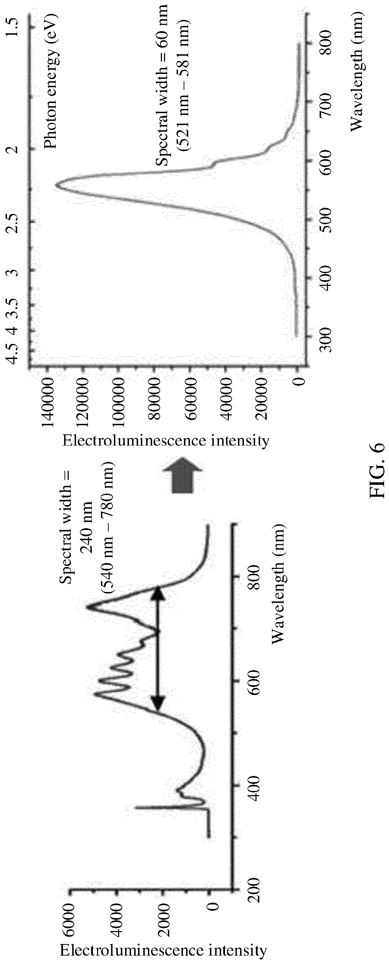

FIG. 6 is a schematic diagram of spectral comparison effects of two quantum dot semiconductor optical amplifiers according to an embodiment of this application. The left figure in FIG. 6 is a spectrum diagram of a quantum dot semiconductor optical amplifier obtained by randomly forming quantum dots by using a two-dimensional plane as a carrier in the related art. As can be seen from the left figure, a spectral width of the quantum dot semiconductor optical amplifier can reach 240 nm. The right diagram in FIG. 6 is a spectrum diagram of a quantum dot semiconductor optical amplifier according to an embodiment of this application. As can be seen from the right diagram, a spectral width of the quantum dot semiconductor optical amplifier is only 60 nm. It can be learned that the wave band covered by the quantum dot semiconductor optical amplifier provided in this embodiment of this application is properly reduced compared with the wave band covered by the quantum dot semiconductor optical amplifier in the related art. Because the covered wave band is reduced, a gain of an optical signal of each wavelength correspondingly increases. As the gain increases, a noise figure is correspondingly reduced.

In this embodiment of this application, because the quantum dot is grown by using the nanowire with a fixed position as a carrier, a degree of freedom of the growth of the quantum dot is limited, so that a position of the quantum dot is fixed and a size is controllable. Because the position of the quantum dot is fixed and the size is controllable, it is avoided that quantum dots located at a same height in active sections of a plurality of nanowires form a two-dimensional plane. In addition, because the size of the quantum dot is controllable, relatively large fluctuation of alloy components caused by random sizes of the quantum dots can be effectively avoided, so that wavelength correlation of a finally prepared quantum dot semiconductor optical amplifier can be reduced, a width of a covered wave band can be properly adjusted, and a noise figure is reduced.

All or some of the preparation method of the quantum dot semiconductor optical amplifier described in the foregoing embodiments may be implemented by means of software, hardware, firmware, or any combination thereof. When software is used to implement the embodiments, the embodiments may be implemented completely or partially in a form of a computer program product. The computer program product includes one or more computer instructions. When the computer instructions are loaded and executed on the computer, the procedure or functions according to the embodiments of the present invention are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, and microwave, or the like) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a digital versatile disc (Digital Versatile Disc, DVD), a semiconductor medium (for example, a solid-state drive (Solid State Disk, SSD)), or the like.

A person of ordinary skill in the art may understand that all or some of the steps of the embodiments may be implemented by hardware or a program instructing related hardware. The program may be stored in a computer-readable storage medium. The storage medium may include: a read-only memory, a magnetic disk, or an optical disc.

## Claims

1. A quantum dot semiconductor optical amplifier QD-SOA, wherein the quantum dot semiconductor optical amplifier comprises an epitaxial wafer (201), a buffer layer (202), a pre-etching layer (203), a plurality of nanowires (204), an n-electrode (205), and a p-electrode (206), wherein
the buffer layer (202) is located on an upper surface of the epitaxial wafer (201), the pre-etching layer (203) is located on an upper surface of the buffer layer (202), and the pre-etching layer (203) comprises a plurality of localization etching holes, wherein the plurality of localization etching holes penetrate the pre-etching layer (203) to expose the buffer layer (202);
the plurality of nanowires (204) are in a one-to-one correspondence to the plurality of localization etching holes, a bottom end of each nanowire (204) is in contact with a bottom of a corresponding localization etching hole, a top end passes through the corresponding localization etching hole, a height of each nanowire (204) is greater than a depth of a corresponding localization etching hole, and each nanowire (204) comprises an n-type section, an active section, and a p-type section, wherein the active section is embedded with a plurality of layers of quantum dots; and
the n-electrode (205) is located on a surface of the epitaxial wafer (201), and the p-electrode (206) is located above the plurality of nanowires (204), wherein
a bottom end of the p-type section is in contact with the top end of the active section, a cross-sectional area of the p-type section gradually increases from the bottom end to a top end of the p-type section until a plurality of p-type sections adjacent to each other in the plurality of p-type sections included in the plurality of nanowires (204) come into contact with each other to form a two-dimensional plane for subsequent preparation of the p-electrode (206) on the two-dimensional plane.

2. The quantum dot semiconductor optical amplifier according to claim 1, wherein distances between every two adjacent layers of the quantum dots in the active section are a first height.

3. The quantum dot semiconductor optical amplifier according to claim 1 or 2, wherein a cross-sectional area of the p-type section is not less than a cross-sectional area of the n-type section, and is not less than a cross-sectional area of the active section.

4. The quantum dot semiconductor optical amplifier according to any one of claims 1 to 3, wherein the n-electrode (205) is located on a lower surface of the epitaxial wafer (201); or
the quantum dot semiconductor optical amplifier comprises a deep trench, the deep trench penetrates the pre-etching layer (203) and the buffer layer (202) to expose an upper surface of the epitaxial wafer (201), the n-electrode (205) is located in the deep trench, and a lower surface of the n-electrode (205) is in contact with the exposed upper surface of the epitaxial wafer (201).

5. The quantum dot semiconductor optical amplifier according to any one of claims 1 to 4, wherein the plurality of localization etching holes are circular holes or regular polygon holes.

6. The quantum dot semiconductor optical amplifier according to any one of claims 1 to 5, wherein the plurality of localization etching holes form a plurality of specific shapes that are periodically arranged, and the specific shape is any one of a regular triangle, a rectangle, a parallelogram, and a regular hexagon.

7. The quantum dot semiconductor optical amplifier according to any one of claims 1 to 6, wherein the quantum dot semiconductor optical amplifier further comprises: a first external driver module, a second external driver module, a first pigtail, a second pigtail, a first optical coupling component, and a second optical coupling component, wherein
the first external driver module, by electrical pins, is connected to the n-electrode (205), and the second external driver module, by electrical pins, is connected to the p-electrode (206); and
the first pigtail is connected, by using the first optical coupling component, to one side of an active gain layer formed by the plurality of active sections that are comprised in the plurality of nanowires (204), and the second pigtail is connected to the other side of the active gain layer by using the second optical coupling component, wherein,
through the first pigtail, a light beam may be input to the quantum dot semiconductor optical amplifier, and, through the second pigtail, the light beam whose power is amplified by the quantum dot semiconductor optical amplifier may be output.

8. A method for preparing a quantum dot semiconductor optical amplifier, wherein the method comprises:
depositing (501) a buffer layer (202) on an upper surface of an epitaxial wafer (201);
preparing (506) an n-electrode (205) on a surface of the epitaxial wafer (201), and depositing (502) a pre-etching layer (203) on the buffer layer (202);
performing etching (503) on the pre-etching layer (203) to obtain a plurality of localization etching holes, wherein the plurality of localization etching holes penetrate the pre-etching layer (203) to expose the buffer layer (202);
growing (504) one nanowire (204) along an axial direction of each of the plurality of localization etching holes from a bottom of the localization etching hole, wherein the nanowire (204) comprises an n-type section, an active section, and a p-type section from bottom to top in a growth direction, and the active section is embedded with a plurality of layers of quantum dots; and
preparing (505) a p-electrode (206) above a plurality of nanowires (204) that are formed along axial directions of the plurality of localization etching holes, to obtain a quantum dot semiconductor optical amplifier, wherein
a bottom end of the p-type section is in contact with the top end of the active section, a cross-sectional area of the p-type section gradually increases from the bottom end to a top end of the p-type section until a plurality of p-type sections adjacent to each other in the plurality of p-type sections included in the plurality of nanowires (204) come into contact with each other to form a two-dimensional plane for subsequent preparation of the p-electrode (206) on the two-dimensional plane.

9. The method according to claim 8, wherein distances between every two adjacent layers of the quantum dots in the active section are a first height.

10. The method according to claim 8 or 9, wherein a cross-sectional area of the p-type section is not less than a cross-sectional area of the n-type section, and is not less than a cross-sectional area of the active section.

11. The method according to any one of claims 8 to 10, wherein the preparing (506) an n-electrode (205) on a surface of the epitaxial wafer (201) comprises: preparing the n electrode (205) on a lower surface of the epitaxial wafer (201).

12. The method according to any one of claims 8 to 10, wherein the preparing (506) an n-electrode (205) on a surface of the epitaxial wafer (201) comprises:
etching a deep trench on the pre-etching layer (203) and the buffer layer (202), wherein the deep trench penetrates the pre-etching layer (203) and the buffer layer (202) to expose an upper surface of the epitaxial wafer (203); and
preparing the n-electrode (205) on the upper surface of the epitaxial wafer (201) exposed by the deep trench.

13. The method according to any one of claims 8 to 12, wherein the performing etching on the pre-etching layer (203) to obtain a plurality of localization etching holes comprises:
generating a mask plate based on a preset geometry; and
performing etching on the pre-etching layer (203) by using the mask plate, to obtain the plurality of localization etching holes.

14. The method according to claim 13, wherein the mask plate comprises a plurality of preset geometries that are periodically arranged, and the preset geometry is any one or any combination of a regular triangle, a rectangle, a parallelogram, and a regular hexagon.

## Patentansprüche

1. Optischer Quantenpunkt-Halbleiterverstärker QD-SOA, wobei der optische Quantenpunkt-Halbleiterverstärker einen epitaktischen Wafer (201), eine Pufferschicht (202), eine Vorätzschicht (203), eine Vielzahl von Nanodrähten (204), eine n-Elektrode (205) und eine p-Elektrode (206) umfasst, wobei
sich die Pufferschicht (202) auf einer oberen Fläche des epitaktischen Wafers (201) befindet, sich die Vorätzschicht (203) auf einer oberen Fläche der Pufferschicht (202) befindet und die Vorätzschicht (203) eine Vielzahl von Lokalisierungsätzlöchern umfasst, wobei die Vielzahl von Lokalisierungsätzlöchern die Vorätzschicht (203) durchdringt, um die Pufferschicht (202) freizulegen;
die Vielzahl von Nanodrähten (204) in einer Eins-zu-eins-Entsprechung zu der Vielzahl von Lokalisierungsätzlöchern steht, ein unteres Ende jedes Nanodrahts (204) in Kontakt mit einem Boden eines entsprechenden Lokalisierungsätzlochs steht, ein oberes Ende durch das entsprechende Lokalisierungsätzloch verläuft, eine Höhe jedes Nanodrahts (204) größer als eine Tiefe eines entsprechenden Lokalisierungsätzlochs ist und jeder Nanodraht (204) einen n-Typ-Abschnitt, einen aktiven Abschnitt und einen p-Typ-Abschnitt umfasst, wobei der aktive Abschnitt mit einer Vielzahl von Schichten aus Quantenpunkten eingebettet ist; und
sich die n-Elektrode (205) auf einer Fläche des epitaktischen Wafers (201) befindet und sich die p-Elektrode (206) über der Vielzahl von Nanodrähten (204) befindet, wobei
ein unteres Ende des p-Typ-Abschnitts in Kontakt mit dem oberen Ende des aktiven Abschnitts steht, eine Querschnittsfläche des p-Typ-Abschnitts von dem unteren Ende zu einem oberen Ende des p-Typ-Abschnitts allmählich zunimmt, bis eine Vielzahl von p-Typ-Abschnitten, die in der Vielzahl von p-Typ-Abschnitten benachbart zueinander und in der Vielzahl von Nanodrähten (204) beinhaltet ist, miteinander in Kontakt kommt, um eine zweidimensionale Ebene für die anschließende Herstellung der p-Elektrode (206) auf der zweidimensionalen Ebene zu bilden.

2. Optischer Quantenpunkt-Halbleiterverstärker nach Anspruch 1, wobei Abstände zwischen jeweils zwei benachbarten Schichten der Quantenpunkte in dem aktiven Abschnitt eine erste Höhe sind.

3. Optischer Quantenpunkt-Halbleiterverstärker nach Anspruch 1 oder 2, wobei eine Querschnittsfläche des p-Typ-Abschnitts nicht kleiner als eine Querschnittsfläche des n-Typ-Abschnitts und nicht kleiner als eine Querschnittsfläche des aktiven Abschnitts ist.

4. Optischer Quantenpunkt-Halbleiterverstärker nach einem der Ansprüche 1 bis 3, wobei sich die n-Elektrode (205) auf einer unteren Fläche des epitaktischen Wafers (201) befindet; oder wobei der optische Quantenpunkt-Halbleiterverstärker einen tiefen Graben umfasst, der tiefe Graben die Vorätzschicht (203) und die Pufferschicht (202) durchdringt, um eine obere Fläche des epitaktischen Wafers (201) freizulegen, sich die n-Elektrode (205) in dem tiefen Graben befindet und eine untere Fläche der n-Elektrode (205) in Kontakt mit der freiliegenden oberen Fläche des epitaktischen Wafers (201) steht.

5. Optischer Quantenpunkt-Halbleiterverstärker nach einem der Ansprüche 1 bis 4, wobei die Vielzahl von Lokalisierungsätzlöchern kreisförmige Löcher oder Löcher regelmäßiger Polygone sind.

6. Optischer Quantenpunkt-Halbleiterverstärker nach einem der Ansprüche 1 bis 5, wobei die Vielzahl von Lokalisierungsätzlöchern eine Vielzahl von spezifischen Formen bilden, die periodisch angeordnet sind, und die spezifische Form eines beliebigen von einem regelmäßigen Dreieck, einem Rechteck, einem Parallelogramm und einem regelmäßigen Sechseck ist.

7. Optischer Quantenpunkt-Halbleiterverstärker nach einem der Ansprüche 1 bis 6, wobei der optische Quantenpunkt-Halbleiterverstärker ferner Folgendes umfasst: ein erstes externes Treibermodul, ein zweites externes Treibermodul, einen ersten Anschlussdraht, einen zweiten Anschlussdraht, eine erste optische Kopplungskomponente und eine zweite optische Kopplungskomponente, wobei
das erste externe Treibermodul über elektrische Stifte mit der n-Elektrode (205) verbunden ist und das zweite externe Treibermodul über elektrische Stifte mit der p-Elektrode (206) verbunden ist; und
der erste Anschlussdraht unter Verwendung der ersten optischen Kopplungskomponente mit einer Seite einer aktiven Verstärkungsschicht, die durch die Vielzahl von aktiven Abschnitten gebildet wird, die in der Vielzahl von Nanodrähten (204) enthalten ist, verbunden ist und der zweite Anschlussdraht unter Verwendung der zweiten optischen Kopplungskomponente mit der anderen Seite der aktiven Verstärkungsschicht verbunden ist, wobei
ein Lichtstrahl über den ersten Anschlussdraht in den optischen Quantenpunkt-Halbleiterverstärker eingegeben werden kann und der Lichtstrahl, dessen Leistung durch den optischen Quantenpunkt-Halbleiterverstärker verstärkt wird, über den zweiten Anschlussdraht ausgegeben werden kann.

8. Verfahren zum Herstellen eines optischen Quantenpunkt-Halbleiterverstärkers, wobei das Verfahren Folgendes umfasst:
Auftragen (501) einer Pufferschicht (202) auf einer oberen Fläche eines epitaktischen Wafers (201);
Herstellen (506) einer n-Elektrode (205) auf einer Fläche des epitaktischen Wafers (201) und Auftragen (502) einer Vorätzschicht (203) auf die Pufferschicht (202);
Durchführen von Ätzen (503) auf der Vorätzschicht (203), um eine Vielzahl von Lokalisierungsätzlöchern zu erlangen, wobei die Vielzahl von Lokalisierungsätzlöchern die Vorätzschicht (203) durchdringt, um die Pufferschicht (202) freizulegen;
Züchten (504) eines Nanodrahts (204) entlang einer axialen Richtung jedes der Vielzahl von Lokalisierungsätzlöchern von einem Boden des Lokalisierungsätzlochs, wobei der Nanodraht (204) in einer Zuchtrichtung von unten nach oben einen n-Typ-Abschnitt, einen aktiven Abschnitt und einen p-Typ-Abschnitt umfasst und der aktive Abschnitt mit einer Vielzahl von Schichten von Quantenpunkten eingebettet ist; und
Herstellen (505) einer p-Elektrode (206) über einer Vielzahl von Nanodrähten (204), die entlang axialer Richtungen der Vielzahl von Lokalisierungsätzlöchern gebildet ist, um einen optischen Quantenpunkt-Halbleiterverstärker zu erlangen, wobei
ein unteres Ende des p-Typ-Abschnitts in Kontakt mit dem oberen Ende des aktiven Abschnitts steht, eine Querschnittsfläche des p-Typ-Abschnitts von dem unteren Ende zu einem oberen Ende des p-Typ-Abschnitts allmählich zunimmt, bis eine Vielzahl von p-Typ-Abschnitten, die in der Vielzahl von p-Typ-Abschnitten benachbart zueinander und in der Vielzahl von Nanodrähten (204) beinhaltet ist, miteinander in Kontakt kommt, um eine zweidimensionale Ebene für die anschließende Herstellung der p-Elektrode (206) auf der zweidimensionalen Ebene zu bilden.

9. Verfahren nach Anspruch 8, wobei Abstände zwischen jeweils zwei benachbarten Schichten der Quantenpunkte in dem aktiven Abschnitt eine erste Höhe sind.

10. Verfahren nach Anspruch 8 oder 9, wobei eine Querschnittsfläche des p-Typ-Abschnitts nicht kleiner als eine Querschnittsfläche des n-Typ-Abschnitts und nicht kleiner als eine Querschnittsfläche des aktiven Abschnitts ist.

11. Verfahren nach einem der Ansprüche 8 bis 10, wobei das Herstellen (506) einer n-Elektrode (205) auf einer Fläche des epitaktischen Wafers (201) Folgendes umfasst: Herstellen der n-Elektrode (205) auf einer unteren Fläche des epitaktischen Wafers (201).

12. Verfahren nach einem der Ansprüche 8 bis 10, wobei das Herstellen (506) einer n-Elektrode (205) auf einer Fläche des epitaktischen Wafers (201) Folgendes umfasst:
Ätzen eines tiefen Grabens auf der Vorätzschicht (203) und der Pufferschicht (202), wobei der tiefe Graben die Vorätzschicht (203) und die Pufferschicht (202) durchdringt, um eine obere Fläche des epitaktischen Wafers (203) freizulegen; und
Herstellen der n-Elektrode (205) auf der oberen Fläche des epitaktischen Wafers (201), die durch den tiefen Graben freigelegt ist.

13. Verfahren nach einem der Ansprüche 8 bis 12, wobei das Durchführen von Ätzen auf der Vorätzschicht (203), um eine Vielzahl von Lokalisierungsätzlöchern zu erlangen, Folgendes umfasst:
Generieren einer Maskenplatte basierend auf einer voreingestellten Geometrie; und
Durchführen von Ätzen auf der Vorätzschicht (203) unter Verwendung der Maskenplatte, um die Vielzahl von Lokalisierungsätzlöchern zu erlangen.

14. Verfahren nach Anspruch 13, wobei die Maskenplatte eine Vielzahl von voreingestellten Geometrien umfasst, die periodisch angeordnet ist, und die voreingestellte Geometrie ein beliebiges oder eine beliebige Kombination aus einem regelmäßigen Dreieck, einem Rechteck, einem Parallelogramm und einem regelmäßigen Sechseck ist.

## Revendications

1. Amplificateur optique semi-conducteur à points quantiques QD-SOA, dans lequel l'amplificateur optique semi-conducteur à points quantiques comprend une tranche épitaxiale (201), une couche tampon (202), une couche de pré-gravure (203), une pluralité de nanofils (204), une électrode n (205) et une électrode p (206), dans lequel
la couche tampon (202) est située sur une surface supérieure de la tranche épitaxiale (201), la couche de pré-gravure (203) est située sur une surface supérieure de la couche tampon (202), et la couche de pré-gravure (203) comprend une pluralité de trous de gravure de localisation, dans lequel la pluralité de trous de gravure de localisation pénétrent dans la couche de pré-gravure (203) pour exposer la couche tampon (202) ;
la pluralité de nanofils (204) sont en correspondance biunivoque avec la pluralité de trous de gravure de localisation, une extrémité inférieure de chaque nanofil (204) est en contact avec un fond d'un trou de gravure de localisation correspondant, une extrémité supérieure passe à travers le trou de gravure de localisation correspondant, une hauteur de chaque nanofil (204) est supérieure à une profondeur d'un trou de gravure de localisation correspondant, et chaque nanofil (204) comprend une section de type n, une section active et une section de type p, dans lequel la section active est intégrée à une pluralité de couches de points quantiques ; et
l'électrode n (205) est située sur une surface de la tranche épitaxiale (201), et l'électrode p (206) est située au-dessus de la pluralité de nanofils (204), dans lequel
une extrémité inférieure de la section de type p est en contact avec l'extrémité supérieure de la section active, une zone de section transversale de la section de type p augmente progressivement à partir de l'extrémité inférieure jusqu'à une extrémité supérieure de la section de type p jusqu'à ce qu'une pluralité de sections de type p adjacentes les unes aux autres dans la pluralité de sections de type p incluses dans la pluralité de nanofils (204) entrent en contact les unes avec les autres pour former un plan bidimensionnel pour une préparation ultérieure de l'électrode p (206) sur le plan bidimensionnel.

2. Amplificateur optique semi-conducteur à points quantiques selon la revendication 1, dans lequel des distances entre deux couches adjacentes des points quantiques dans la section active sont une première hauteur.

3. Amplificateur optique semi-conducteur à points quantiques selon la revendication 1 ou 2, dans lequel une zone de section transversale de la section de type p n'est pas inférieure à une zone de section transversale de la section de type n, et n'est pas inférieure à une zone de section transversale de la section active.

4. Amplificateur optique semi-conducteur à points quantiques selon l'une quelconque des revendications 1 à 3, dans lequel l'électrode n (205) est située sur une surface inférieure de la tranche épitaxiale (201) ; ou
l'amplificateur optique semi-conducteur à points quantiques comprend une tranchée profonde, la tranchée profonde pénètre dans la couche de pré-gravure (203) et la couche tampon (202) pour exposer une surface supérieure de la tranche épitaxiale (201), l'électrode n (205) est située dans la tranchée profonde, et une surface inférieure de l'électrode n (205) est en contact avec la surface supérieure exposée de la tranche épitaxiale (201) .

5. Amplificateur optique semi-conducteur à points quantiques selon l'une quelconque des revendications 1 à 4, dans lequel la pluralité de trous de gravure de localisation sont des trous circulaires ou des trous polygonaux réguliers.

6. Amplificateur optique semi-conducteur à points quantiques selon l'une quelconque des revendications 1 à 5, dans lequel la pluralité de trous de gravure de localisation forment une pluralité de formes spécifiques qui sont agencées périodiquement, et la forme spécifique est l'un quelconque d'un triangle régulier, d'un rectangle, d'un parallélogramme et d'un hexagone régulier.

7. Amplificateur optique semi-conducteur à points quantiques selon l'une quelconque des revendications 1 à 6, dans lequel l'amplificateur optique semi-conducteur à points quantiques comprend en outre : un premier module pilote externe, un second module pilote externe, une première queue de cochon, une seconde queue de cochon, un premier élément de couplage optique, et un second élément de couplage optique, dans lequel
le premier module pilote externe, par des broches électriques, est connecté à l'électrode n (205), et le second module pilote externe, par des broches électriques, est connecté à l'électrode p (206) ; et
la première queue de cochon est connectée, à l'aide du premier élément de couplage optique, à un côté d'une couche de gain actif formée par la pluralité de sections actives qui sont comprises dans la pluralité de nanofils (204), et la seconde queue de cochon est connectée à l'autre côté de la couche de gain actif à l'aide du second élément de couplage optique, dans lequel,
à travers la première queue de cochon, un faisceau de lumière peut être entré dans l'amplificateur optique semi-conducteur à points quantiques, et, à travers la seconde queue de cochon, le faisceau de lumière dont la puissance est amplifiée par l'amplificateur optique semi-conducteur à points quantiques peut être émis.

8. Procédé de préparation d'un amplificateur optique semi-conducteur à points quantiques, dans lequel le procédé comprend :
le dépôt (501) d'une couche tampon (202) sur une surface supérieure d'une tranche épitaxiale (201) ;
la préparation (506) d'une électrode n (205) sur une surface de la tranche épitaxiale (201) et le dépôt (502) d'une couche de pré-gravure (203) sur la couche tampon (202) ;
la réalisation d'une gravure (503) sur la couche de pré-gravure (203) pour obtenir une pluralité de trous de gravure de localisation, dans lequel la pluralité de trous de gravure de localisation pénètrent dans la couche de pré-gravure (203) pour exposer la couche tampon (202) ;
la croissance (504) d'un nanofil (204) le long d'une direction axiale de chacun de la pluralité de trous de gravure de localisation à partir d'un fond du trou de gravure de localisation, dans lequel le nanofil (204) comprend une section de type n, une section active et une section de type p de bas en haut dans une direction de croissance, et la section active est incrustée d'une pluralité de couches de points quantiques ; et
la préparation (505) d'une électrode p (206) au-dessus d'une pluralité de nanofils (204) qui sont formés le long de directions axiales de la pluralité de trous de gravure de localisation, pour obtenir un amplificateur optique semi-conducteur à points quantiques, dans lequel
une extrémité inférieure de la section de type p est en contact avec l'extrémité supérieure de la section active, une zone de section transversale de la section de type p augmente progressivement à partir de l'extrémité inférieure jusqu'à une extrémité supérieure de la section de type p jusqu'à ce qu'une pluralité de sections de type p adjacentes les unes aux autres dans la pluralité de sections de type p incluses dans la pluralité de nanofils (204) entrent en contact les unes avec les autres pour former un plan bidimensionnel pour une préparation ultérieure de l'électrode p (206) sur le plan bidimensionnel.

9. Procédé selon la revendication 8, dans lequel des distances entre deux couches adjacentes des points quantiques dans la section active sont une première hauteur.

10. Procédé selon la revendication 8 ou 9, dans lequel une zone de section transversale de la section de type p n'est pas inférieure à une zone de section transversale de la section de type n, et n'est pas inférieure à une zone de section transversale de la section active.

11. Procédé selon l'une quelconque des revendications 8 à 10, dans lequel la préparation (506) d'une électrode n (205) sur une surface de la tranche épitaxiale (201) comprend : la préparation de l'électrode n (205) sur une surface inférieure de la tranche épitaxiale (201).

12. Procédé selon l'une quelconque des revendications 8 à 10, dans lequel la préparation (506) d'une électrode n (205) sur une surface de la tranche épitaxiale (201) comprend :
la gravure d'une tranchée profonde sur la couche de pré-gravure (203) et la couche tampon (202), dans lequel la tranchée profonde pénètre dans la couche de pré-gravure (203) et la couche tampon (202) pour exposer une surface supérieure de la tranche épitaxiale (203) ; et
la préparation de l'électrode n (205) sur la surface supérieure de la tranche épitaxiale (201) exposée par la tranchée profonde.

13. Procédé selon l'une quelconque des revendications 8 à 12, dans lequel la réalisation d'une gravure sur la couche de pré-gravure (203) pour obtenir une pluralité de trous de gravure de localisation comprend :
la génération d'une plaque de masque sur la base d'une géométrie prédéfinie ; et
la réalisation d'une gravure sur la couche de pré-gravure (203) à l'aide de la plaque de masque, pour obtenir la pluralité de trous de gravure de localisation.

14. Procédé selon la revendication 13, dans lequel la plaque de masque comprend une pluralité de géométries prédéfinies qui sont agencées périodiquement, et la géométrie prédéfinie est l'un quelconque d'un triangle régulier, d'un rectangle, d'un parallélogramme et d'un hexagone régulier ou toute combinaison de ceux-ci.
